(19) Europäisches Patentamt
European Patent Office
Office européen des brevets

(11) **EP 4 779 404 A1**

(12) **EUROPEAN PATENT APPLICATION**

(43) Date of publication:
**22.07.2026 Bulletin 2026/30**

(21) Application number: **26152268.4**

(22) Date of filing: **16.01.2026**

(51) International Patent Classification (IPC):
*G03F 7/00* *(2006.01)*

(52) Cooperative Patent Classification (CPC):
**G03F 7/70504; G03F 7/70258**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **21.01.2025 JP 2025008577**

(71) Applicant: **CANON KABUSHIKI KAISHA**
**Ohta-ku**
**Tokyo 146-8501 (JP)**

(72) Inventors:
• **TAKIGUCHI, Takahiro**
**Ohta-ku, Tokyo, 146-8501 (JP)**
• **MOIZUMI, Jun**
**Ohta-ku, Tokyo, 146-8501 (JP)**

(74) Representative: **TBK**
**Bavariaring 4-6**
**80336 München (DE)**

(54) **METHOD OF OBTAINING PREDICTION MODEL, EXPOSURE APPARATUS, EXPOSURE METHOD, INFORMATION PROCESSING APPARATUS, ARTICLE MANUFACTURING METHOD, AND PROGRAM**

(57) A method of obtaining a prediction model for predicting fluctuation of imaging characteristics of a projection optical system which is used in an exposure apparatus that exposes a substrate via an original, the method including setting a first value, which is a value of a first coefficient in a first prediction model that is set based on a result of measuring fluctuation of imaging characteristics of a first projection optical system in a first exposure apparatus including the first projection optical system, as a value of the first coefficient in a second prediction model for predicting fluctuation of imaging characteristics of a second projection optical system in a second exposure apparatus including the second projection optical system, while temporarily setting a value of a second coefficient in the second prediction model to a default value.

**F I G. 6**

START

S601 SET SECOND EXPOSURE APPARATUS AS APPARATUS OF SAME TYPE AS FIRST EXPOSURE APPARATUS

S602 IS PREDICTION MODEL SET IN FIRST EXPOSURE APPARATUS?

NO → S606 OBTAIN CORRECTION COEFFICIENT lc AND AREA-DEPENDENT COEFFICIENT c IN SECOND PREDICTION MODEL AND SET TO SECOND PREDICTION MODEL

YES → S603 SET AREA-DEPENDENT COEFFICIENT c IN FIRST PREDICTION MODEL AS AREA-DEPENDENT COEFFICIENT c IN SECOND PREDICTION MODEL

S604 EXECUTE MAGNIFICATION MEASUREMENT AND ACQUIRE MEASUREMENT

S605 OBTAIN CORRECTION COEFFICIENT lc IN SECOND PREDICTION MODEL AND SET TO SECOND PREDICTION MODEL

END

EP 4 779 404 A1

## Description

TECHNICAL FIELD

The present disclosure relates to a method of obtaining a prediction model, an exposure apparatus, an exposure method, an information processing apparatus, an article manufacturing method, and a program.

BACKGROUND

In recent years, improvement in overlay accuracy is demanded in the exposure step of a semiconductor process. For example, for some users, the allowable value for fluctuation of magnification caused by exposure heat within a lot is 0.100 ppm or less. To achieve this, for example, closed correction for performing calibration within a lot is executed. However, closed correction leads to degradation of productivity.

Therefore, a technique of executing open correction has been proposed that uses a prediction model to predict fluctuation of the dynamic imaging characteristics of a projection optical system, which is caused by exposure heat, for each exposure condition (see patent literature 1). To perform optimal prediction in open correction, it is necessary to wait until the influence of exposure heat on the projection optical system disappears (cooling) before measuring the imaging characteristics during exposure. Japanese Patent Laid-Open No. 2013-115348 discloses a technique for, when predicting the fluctuation of imaging characteristics, accurately obtaining the fluctuation amount of imaging characteristics by calculating the fluctuation amount (exposure coefficient) corresponding to the wavelength band of exposure light.

SUMMARY

However, as in the conventional technique, optimizing the prediction model by measuring the imaging characteristics during exposure for each exposure condition after cooling degrades productivity. To suppress degradation of productivity, it is conceivable to apply a prediction model optimized in one apparatus to another apparatus, but this cannot avoid a decrease in accuracy (prediction accuracy) of predicting the fluctuation of imaging characteristics.

The present disclosure provides a technique advantageous in obtaining a prediction model for predicting the fluctuation of the imaging characteristics of a projection optical system.

The present disclosure in its first aspect provides a method of obtaining a prediction model as specified in claim 1. Optional features are specified in claims 2 to 7.

The present disclosure in its second aspect provides an exposure apparatus as specified in claim 8.

The present disclosure in its third aspect provides an exposure method as specified in claim 9.

The present disclosure in its fourth aspect provides an information processing apparatus as specified in claim 10.

The present disclosure in its fifth aspect provides an article manufacturing method as specified in claim 11.

The present disclosure in its sixth aspect provides a program as specified in claim 12.

Features of the present disclosure will become apparent from the following description of embodiments with reference to the attached drawings. The following description of embodiments is described by way of example.

BRIEF DESCRIPTION OF THE DRAWINGS

Fig. 1 is a schematic view illustrating configurations of an exposure apparatus according to an aspect of the present disclosure.

Fig. 2 is a graph illustrating the change in light amount detected by a light detector.

Fig. 3 is a view illustrating the result of correcting an exposure history by using a prediction model.

Fig. 4 is a view illustrating the result of correcting the exposure history by deploying the prediction model optimized for the first exposure apparatus in the second exposure apparatus.

Fig. 5 is a view illustrating the result of correcting the exposure history by using a prediction model according to an embodiment.

Fig. 6 is a flowchart for explaining an example of a process of obtaining a prediction model according to the embodiment.

Fig. 7 is a flowchart for explaining an example of a process of obtaining a prediction model according to the embodiment.

DESCRIPTION OF THE EMBODIMENTS

Embodiments will be described in detail below with reference to the accompanying drawings. Note that the following embodiments do not limit the claims. A plurality of features are described in the embodiments, but not all the features are essential, and a plurality of features may be arbitrarily combined. In the accompanying drawings, the same reference numerals denote the same or similar parts and a repetitive description thereof will be omitted.

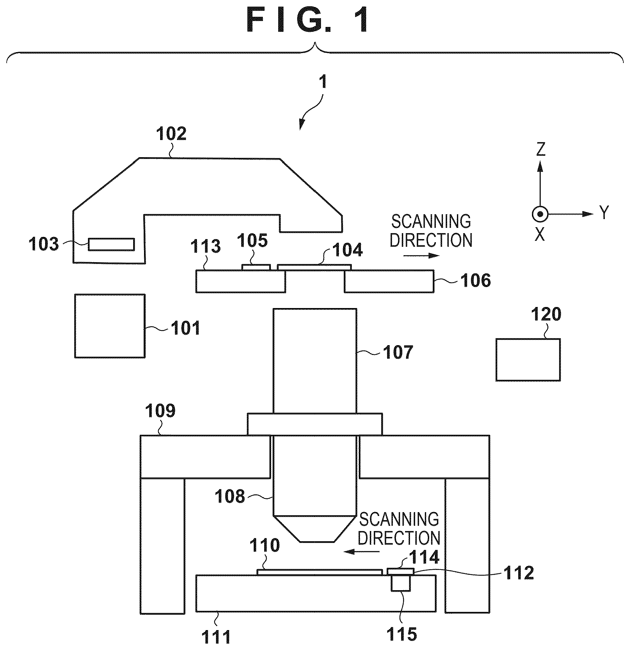

Fig. 1 is a schematic view illustrating configurations of an exposure apparatus 1 according to an aspect of the present disclosure. The exposure apparatus 1 is a lithography apparatus that is used for the photolithography process as the manufacturing process of a device such as a semiconductor device or flat panel display (FPD), and forms a pattern on a substrate. The exposure apparatus 1 transfers the pattern of an original to a substrate by exposing the substrate via the original.

In this embodiment, the exposure apparatus 1 is implemented as a scanning exposure apparatus (scanner) that transfers the pattern of an original to a substrate while synchronously scanning the original and the substrate in the scanning direction (that is, by a step-and-scan method). Note that the exposure apparatus 1 may be implemented as an exposure apparatus (stepper) that transfers the pattern of an original to a substrate while stopping the original and the substrate (that is, by a step-and-repeat method).

In this specification and the accompanying drawings, an XYZ coordinate system is defined such that the horizontal plane is the X-Y plane, and the vertical direction is the Z-axis direction. Directions respectively parallel to the X-axis, the Y-axis, and the Z-axis in the XYZ coordinate system will be defined as the X direction, the Y direction, and the Z direction. A rotation about the X-axis, a rotation about the Y-axis, and a rotation about the Z-axis will be defined as $\theta X$, $\theta Y$, and $\theta Z$, respectively. The X-Y plane is a plane parallel to the plane on which the substrate is arranged. The Z direction is a direction coincident with the optical axis of the projection optical system.

As illustrated in Fig. 1, the exposure apparatus 1 includes an illumination optical system 102 that illuminates an original 104 with light from a light source 101, and an original stage 106 that holds the original 104. The exposure apparatus 1 also includes a projection optical system 107 that projects the pattern of the original 104 onto a substrate 110, a substrate stage 111 that holds the substrate 110, and a control unit 120.

The light from the light source 101 enters the illumination optical system 102, generates a desirable effective light source distribution via a diffraction optical element 103, and is applied to the original 104. The light applied to the original 104 where the pattern to be transferred to the substrate 110 is drawn passes through the original 104, and reaches the substrate 110 via the projection optical system 107. Thus, the pattern of the original 104 is reduction-projected onto the substrate 110.

The original 104 is held by the original stage 106. When performing exposure, the original stage 106 is scan-driven along the Y direction. The substrate 110 is held by the substrate stage 111. When performing exposure, the substrate stage 111 is scan-driven along the Y direction in a direction opposite to the scan-driving direction of the original stage 106. When the previous exposure ends, the substrate stage 111 is step-driven for the next exposure.

One or both of the original 104 arranged on the original stage 106 and a reference plate 105 arranged on the original stage 106 are provided with an original-side mark 113 for aerial image measurement. The original-side mark 113 includes, for example, a line-and-space pattern where patterns are periodically arranged. On the other hand, a detection plate 112 provided with a substrate-side mark 114 for aerial image measurement is arranged on the substrate stage 111. The substrate-side mark 114 includes a line-and-space pattern where patterns are arranged at the same pitch as in the original-side mark 113. A light detector 115 is arranged below the detection plate 112.

In the line-and-space pattern constituting each of the original-side mark 113 and the substrate-side mark 114, lines are made of chrome, and spaces are made of glass. When measuring an aerial image, the original stage 106 is arranged such that the light from the light source 101 is applied to the original-side mark 113 provided in the original 104 or the reference plate 105 via the illumination optical system 102. The light having passed through the original-side mark 113 reaches the substrate-side mark 114 provided in the detection plate 112 via the projection optical system 107, passes through the substrate-side mark 114, and is detected by the light detector 115.

The control unit 120 is constituted by, for example, an information processing apparatus (computer) including a CPU, a memory, and the like, and comprehensively controls the respective units of the exposure apparatus 1 in accordance with programs stored in a storage unit or the like. The control unit 120 controls an exposure process (exposure method) of exposing the substrate 110 while projecting the pattern of the original 104 onto the substrate 110 via the projection optical system 107, that is, transferring the pattern of the original 104 to the substrate 110.

Here, aerial image measurement as a method for measuring an image shift will be described. The light from the light source 101 is applied to the original-side mark 113 via the illumination optical system 102. The light having passed through the original-side mark 113 is reduction-projected onto the substrate-side mark 114 via the projection optical system 107. In this state, the substrate stage 111 is scan-driven in the X direction (the direction orthogonal to the optical axis direction of the projection optical system 107). With this, the image of the original-side mark 113 overlaps the substrate-side mark 114 at the imaging position of the projection optical system 107, so that the light amount detected by the light detector 115 becomes maximum. On the other hand, when the substrate-side mark 114 is shifted from the imaging position of the projection optical system 107, the overlap between the image of the original-side mark 113 and the substrate-side mark 114 decreases, so that the light amount detected by the light detector 115 decreases.

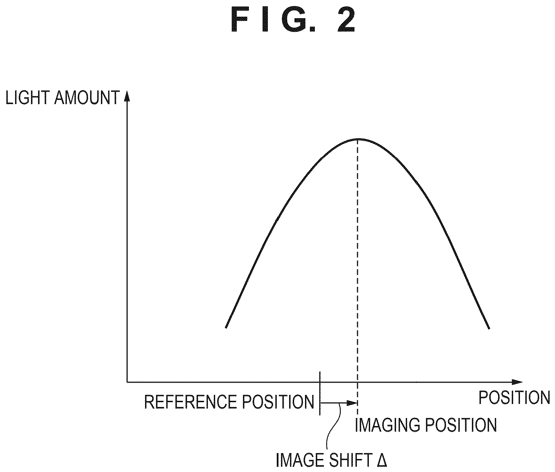

Fig. 2 is a graph illustrating the change in light amount detected by the light detector 115 in a case where, while the original-side mark 113 is reduction-projected onto the substrate-side mark 114, the substrate stage 111 is scan-driven in the X direction across the imaging position of the projection optical system 107. In Fig. 2, the abscissa represents the position (X direction) of the substrate stage 111, and the ordinate represents the light amount detected by the light detector 115. With reference to Fig. 2, the light amount detected by the light detector 115 draws an upward convex curve. The peak position of the curve is set as the imaging position of the projection optical system 107, and the difference from the reference position is set as an image shift $\Delta$. The reference position is the imaging position when the projection optical system 107 is in the ideal state. The reference position is set in advance in the exposure apparatus 1. In this embodiment, the method for measuring the image shift is merely an example, and another method may be used to measure the image shift. By measuring the image shift for each of the original-side marks 113 provided at two different positions on the original 104 along the X direction, the magnification can be obtained from the measurement results of the image shifts and the X-direction span between the two positions converted into the image side. More specifically, when the measurement result of one image shift is $\Delta XL$, the measurement result of the other image shift is $\Delta XR$, and the X-direction span between the two positions is SL, the magnification is obtained by $(\Delta XL - \Delta XR)/SL$. In this specification, this measurement will be referred to as magnification measurement.

Prediction of the fluctuation of the imaging characteristics of the projection optical system 107 caused by exposure heat (to be referred to as the "exposure history" hereinafter) will be described below. Note that in this embodiment, prediction of the exposure history is assumed to be performed in the control unit 120, but may be performed in an information processing apparatus outside the exposure apparatus 1.

In the exposure apparatus 1, the light (exposure light) from the light source 101 is applied to the pattern of the original 104 via the illumination optical system 102, and the light having passed through the original 104 is imaged, via the projection optical system 107, on the substrate 110 held by the substrate stage 111. When exposure light is applied to the projection optical system 107, the exposure light is absorbed by the glass material itself of the optical element (such as a lens) constituting the projection optical system 107 or an antireflection film formed on the surface of the optical element. Due to this, the temperature of the optical element constituting the projection optical system 107 rises, and the optical characteristics, such as the refractive index, of the optical element change. If the optical characteristics of the optical element constituting the projection optical system 107 change, the imaging characteristics of the projection optical system 107 change. Here, the imaging characteristics of the projection optical system 107 include at least one of magnification, focus, distortion, astigmatism, spherical aberration, comatic aberration, and wave aberration. In this embodiment, magnification will be exemplified to describe the prediction model for the exposure history. The magnification of the projection optical system 107 caused by exposure heat will be referred to as the exposure magnification.

First, when an exposure process for the first lot is started, magnification measurement is executed before exposure of the leading substrate 110 included in the lot to acquire the lot leading magnification, which indicates the magnification of the projection optical system 107 before exposure. The lot leading magnification includes the static magnification of the projection optical system 107, and the arrangement error of the original-side mark 113.

Then, after the exposure process for the first lot is started, magnification measurement is executed for each substrate 110 or at the timing of the pre-designated substrate 110, thereby acquiring the intra-lot magnification, which indicates the exposure magnification (fluctuation thereof) of the projection optical system 107 within the lot. The intra-lot magnification includes the static magnification of the projection optical system 107, the arrangement error of the original-side mark 113, and the exposure magnification which fluctuates by exposure.

Next, when an exposure process using the different original 104 is started for a lot different from the first lot, magnification measurement is executed as in the first lot, thereby acquiring the lot leading magnification and the intra-lot magnification. The lot leading magnification acquired here includes the static magnification of the projection optical system 107, the arrangement error of the original-side mark 113 different from that in the first lot, and the influence of the exposure magnification in the first lot. The intra-lot magnification includes the static magnification of the projection optical system 107, the arrangement error of the original-side mark 113 different from that in the first lot, and the exposure magnification in the different lot.

The exposure process for each of a plurality of lots is repeated while executing magnification measurement for each exposure condition. Here, a lot means a series of process units for exposing 25 substrates 110 while using a recipe (exposure recipe) including correction coefficients for correcting the exposure load and the exposure history. The recipe indicates the actual user process, and includes exposure conditions in the exposure process, such as the original 104, the illumination condition, the exposure amount, the shot size (the size of the shot region), the number of shots, and the transmittance of the original 104.

With respect to the fluctuation of the magnification of the projection optical system 107 acquired in this manner, the exposure history is corrected using a prediction model expressed by:

$$\phi N = lo - (lo - \phi N - 1) \times \exp((-1) \times heatTime/K) \qquad ...(1)$$

$$lo = Ic \times \{Dose \times mbWy \times ((1/HeatTime)/slitWy)\}/\{Dose_0 \times Wy_0 \times v_0/slitWy/(slitWy + Wy_0)\} \times$$

$$T/T_0 \times (mbWx/Wx_0) \times ((\exp(c) + \exp(-c)))/((\exp(c \times (mbWx/Wx0)) + \exp(-c \times (mbWx/Wx0))))$$

$$...(2)$$

In equations (1) and (2), $\phi$ represents the prediction value of the exposure magnification, which is the fluctuation of the imaging characteristics of the projection optical system 107, N represents the timing of predicting the exposure magnification of the projection optical system 107, heatTime represents the exposure time, and K represents the time constant. lo represents the exposure load, Dose represents the exposure amount, mbWx and mbWy represent the X-direction aperture width and the Y-direction aperture width, respectively, of the masking blade defining the exposure region, and slitWy represents the design value of the Y-direction width of the exposure region (exposure slit). Dose0 represents the reference exposure amount, Wx0 and Wy0 represent the X-direction width and the Y-direction width, respectively, of the reference exposure region, v0 represents the reference scan speed, T represents the transmittance of the original 104, and T0 represents the transmittance of a reference original. Ic represents the correction coefficient for correcting the exposure history, that is, the saturation amount at a unit exposure load, and c represents the area-dependent coefficient that indicates the influence on the exposure load relative to the aperture width of the masking blade.

For example, magnification measurements are executed while performing exposure processes on a lot by using one of recipes respectively including three exposure conditions different only in the X-direction aperture width mbWx of the masking blade. Then, based on the lot leading magnification and the intra-lot magnification acquired by magnification measurements, the correction coefficient Ic for correcting the exposure history and the area-dependent coefficient c are set (decided) so as to decrease the difference (residual correction error) between the prediction value of the prediction model and the measurement value. By using the prediction model including the correction coefficient Ic and the area-dependent coefficient c set as described above, even if the aperture width mbWx is different, as long as the remaining exposure conditions are the same between the recipes, the exposure history can be corrected with high accuracy without newly obtaining these coefficients.

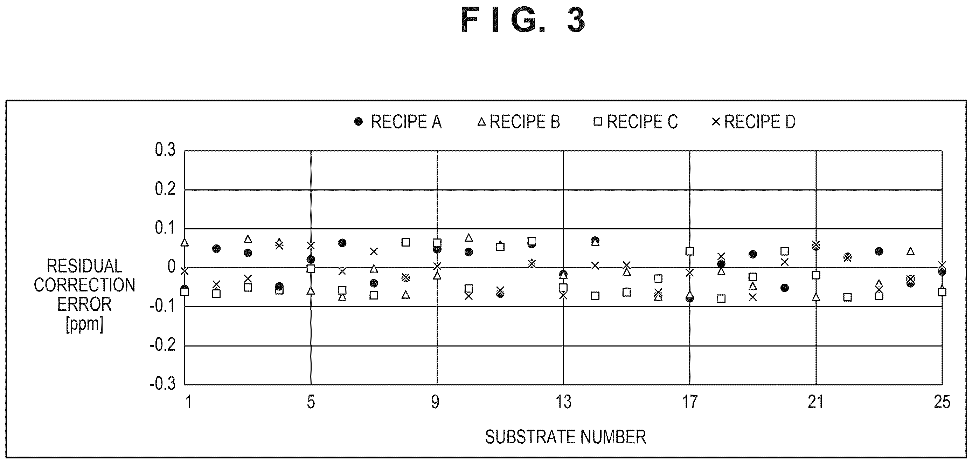

Fig. 3 is a view illustrating the result of correcting the exposure history using the prediction model expressed by equations (1) and (2). Fig. 3 illustrates the residual correction errors corresponding to recipes A, B, C, and D, respectively, that include four exposure conditions different only in the X-direction aperture width mbWx of the masking blade, respectively. In Fig. 3, the abscissa represents the substrate number in the lot, and the ordinate represents the residual correction error. With reference to Fig. 3, it can be seen that this prediction model does not include the correction coefficient Ic and the area-dependent coefficient c optimized for each of the recipes A, B, C, and D, but the residual correction errors are suppressed within $\pm 0.100$ ppm, so that the exposure histories are corrected with high accuracy. Note that, to set such a prediction model (the correction coefficient Ic and the area-dependent coefficient c), it is necessary to execute magnification measurements on at least three or more lots. Hence, attempting to optimize the prediction model for each exposure apparatus leads to degradation of productivity.

To suppress degradation of productivity, consider a case where a prediction model optimized (set) for the first exposure apparatus including the first projection optical system, which is one exposure apparatus, is deployed (repurposed) in the second exposure apparatus including the second projection optical system, which is the other exposure apparatus. Note that the first exposure apparatus and the second exposure apparatus are apparatuses of the same type. Apparatuses of the same type are apparatuses manufactured from the same design data (the design data such as the number of optical elements constituting the projection optical system and the refractive indices thereof), more specifically, apparatuses of the same model number or product name.

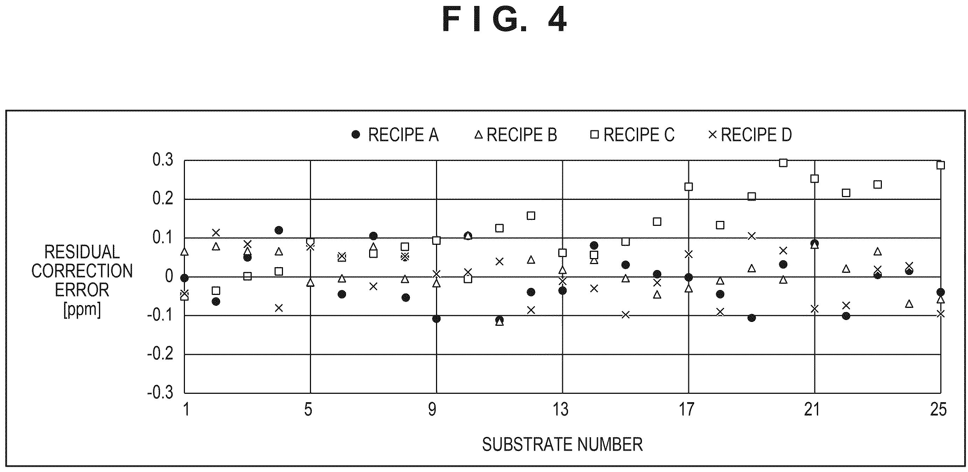

Fig. 4 is a view illustrating the result of correcting the exposure history by deploying the prediction model optimized for the first exposure apparatus in the second exposure apparatus. Similar to Fig. 3, Fig. 4 illustrates the residual correction errors corresponding to the recipes A, B, C, and D, respectively, that include four exposure conditions different only in the X-direction aperture width mbWx of the masking blade, respectively. In Fig. 4, the abscissa represents the substrate number in the lot, and the ordinate represents the residual correction error. With reference to Fig. 4, it can be seen that some residual correction errors exceed 0.100 ppm since the prediction model is not optimized for the second exposure apparatus. This means that it is difficult to deploy the prediction model including the correction coefficient Ic and the area-dependent coefficient c optimized (set) for the first exposure apparatus in the second exposure apparatus intact.

Therefore, in this embodiment, the prediction model, which includes only the area-dependent coefficient c out of the correction coefficient Ic and the area-dependent coefficient c optimized (set) in the first exposure apparatus, is deployed in the second exposure apparatus. More specifically, as the prediction model in the second exposure apparatus, the area-dependent coefficient c is set to the area-dependent coefficient c optimized in the first exposure apparatus, and the correction coefficient Ic is temporarily set to a default value defined in the second exposure apparatus. By using this prediction model, magnification measurements are executed while performing exposure processes on a lot in the second exposure apparatus. Based on the lot leading magnification and the intra-lot magnification acquired in the magnification measurements, the correction coefficient Ic for correcting the exposure history is set (decided) so as to decrease the difference (residual correction error) between the prediction value of the prediction model and the measurement value. At this time, as the exposure condition, the transmittance of the original 104 is set high (for example, 40% or higher) and the X-direction aperture width mbWx of the masking blade is set at middle level (for example, within a range of 20 mm (inclusive) to 22 mm (inclusive)). Note that the area-dependent coefficient c is a coefficient common to different exposure apparatuses, that is, a coefficient (first coefficient) common to the first exposure apparatus (first projection optical system) and the second exposure apparatus (second projection optical system). On the other hand, the correction coefficient Ic is a coefficient dependent on the individual exposure apparatus, that is, a coefficient (second coefficient) specific to each of the first exposure apparatus and the second exposure apparatus.

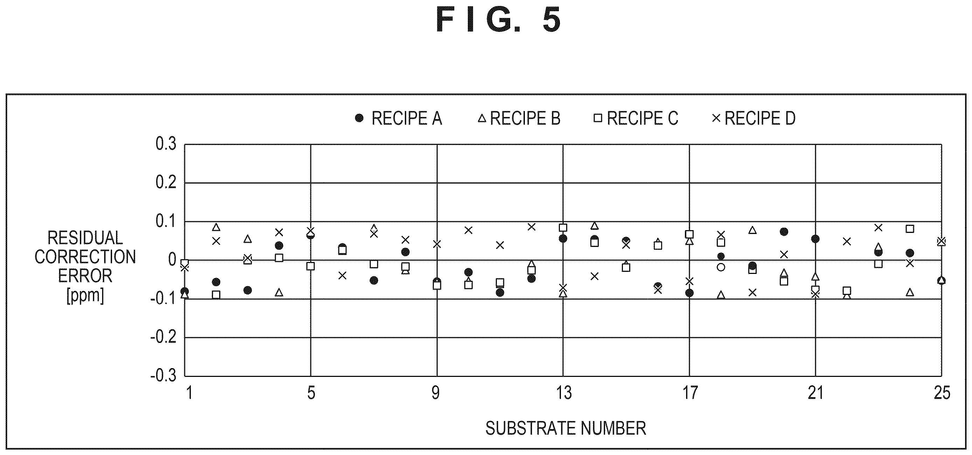

Fig. 5 is a view illustrating the result of correcting the exposure history by using the prediction model including the correction coefficient Ic set in the second exposure apparatus, and the area-dependent coefficient c set in the first exposure apparatus. Similar to Figs. 3 and 4, Fig. 5 illustrates the residual correction errors corresponding to the recipes A, B, C, and D, respectively, that include four exposure conditions different only in the X-direction aperture width mbWx of the masking blade, respectively. In Fig. 5, the abscissa represents the substrate number in the lot, and the ordinate represents the residual correction error. With reference to Fig. 5, it can be seen that the residual correction errors are suppressed within $\pm 0.100$ ppm even for the recipes that have large residual correction errors in Fig. 4, so that the exposure histories are corrected with high accuracy.

As described above, in this embodiment, it is possible to set (decide), from the measurement values of magnification measurements for one lot, the correction coefficient Ic having the accuracy similar to that of the correction coefficient Ic set from the measurement values of magnification measurements for at least three or more lots. Hence, in the exposure apparatus 1, it is possible to correct the exposure history with high accuracy while suppressing degradation of productivity.

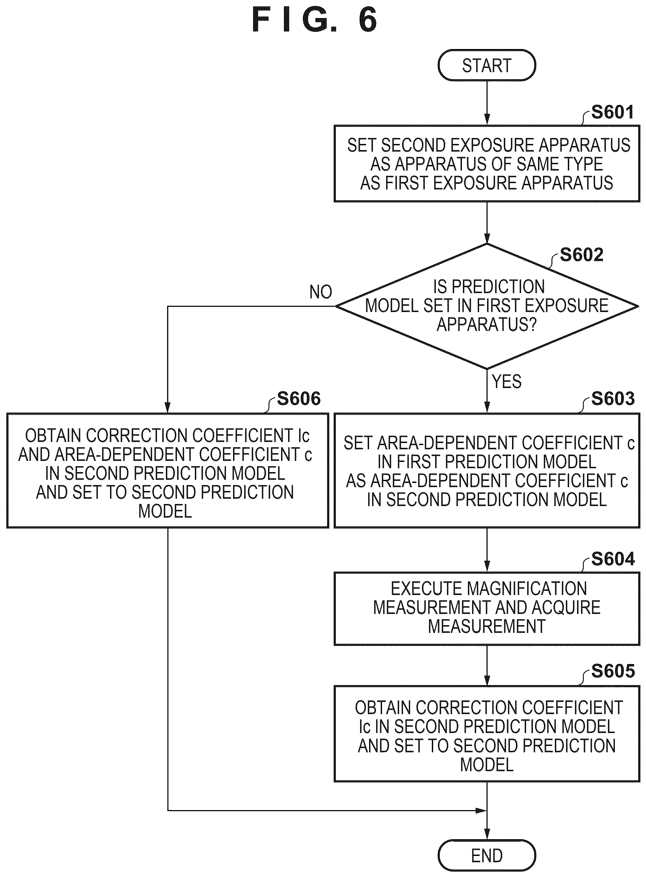

With reference to Fig. 6, a process of obtaining a prediction model for predicting the fluctuation of the imaging characteristics of the projection optical system 107 according to this embodiment will be described. In this embodiment, the process is assumed to be performed in the control unit 120, but may be performed in an information processing apparatus outside the exposure apparatus 1. Here, a description will be given assuming that the exposure apparatus 1 including the projection optical system 107 is the second exposure apparatus including the second projection optical system, and another exposure apparatus including a different projection optical system is the first exposure apparatus including the first projection optical system.

In step S601, the second exposure apparatus (exposure apparatus 1) including the second projection optical system (projection optical system 107) is set as the apparatus of the same type as the first exposure apparatus including the first projection optical system.

In step S602, it is determined whether a prediction model corresponding to the exposure condition of an exposure process to be executed in the second exposure apparatus is set in the first exposure apparatus. More specifically, it is determined whether the area-dependent coefficient c (the first value, which is a value of the first coefficient) in the prediction model (first prediction model) applied to the first exposure apparatus is set based on the result of measuring the fluctuation of the exposure magnification of the first projection optical system in the first exposure apparatus. If the prediction model is set in the first exposure apparatus, the process transitions to step S603. If the prediction model is not set in the first exposure apparatus, the process transitions to step S606.

In step S603 (first step), the area-dependent coefficient c in the prediction model applied to the first exposure apparatus is set as the area-dependent coefficient c (a value of the first coefficient) in the prediction model (second prediction model) applied to the second exposure apparatus. In addition, the correction coefficient Ic (a value of the second coefficient) in the prediction model applied to the second exposure apparatus is temporarily set to a default value. In this embodiment, the prediction model set with the correction coefficient Ic and the area-dependent coefficient c is acquired from the first exposure apparatus, and the area-dependent coefficient c in this prediction model is deployed as the area-dependent coefficient c in the prediction model applied to the second exposure apparatus.

In step S604 (second step), using the prediction model set in step S603, a measurement value is acquired by executing magnification measurement while performing an exposure process on a lot in the second exposure apparatus. More specifically, using the prediction model set in step S603, prediction values are obtained by predicting the fluctuation of the magnification of the second projection optical system, and measurement values, that is, a lot leading magnification and an intra-lot magnification, are acquired by measuring the fluctuation of the magnification of the second projection optical system while performing correction based on the prediction values. At this time, as the exposure condition, the transmittance of the original 104 is set high, and the X-direction aperture width mbWx of the masking blade is set at middle level.

In step S605 (third step), the correction coefficient Ic (the second value, which is a value of the second coefficient) is obtained based on the measurement values acquired in step S604, and the obtained correction coefficient Ic is set as the correction coefficient Ic in the prediction model applied to the second exposure apparatus in place of the default value.

In step S606, magnification measurements are executed on at least three or more lots while performing exposure processes using exposure conditions different from each other, thereby obtaining and setting the correction coefficient Ic and the area-dependent coefficient c in the prediction model applied to the second exposure apparatus.

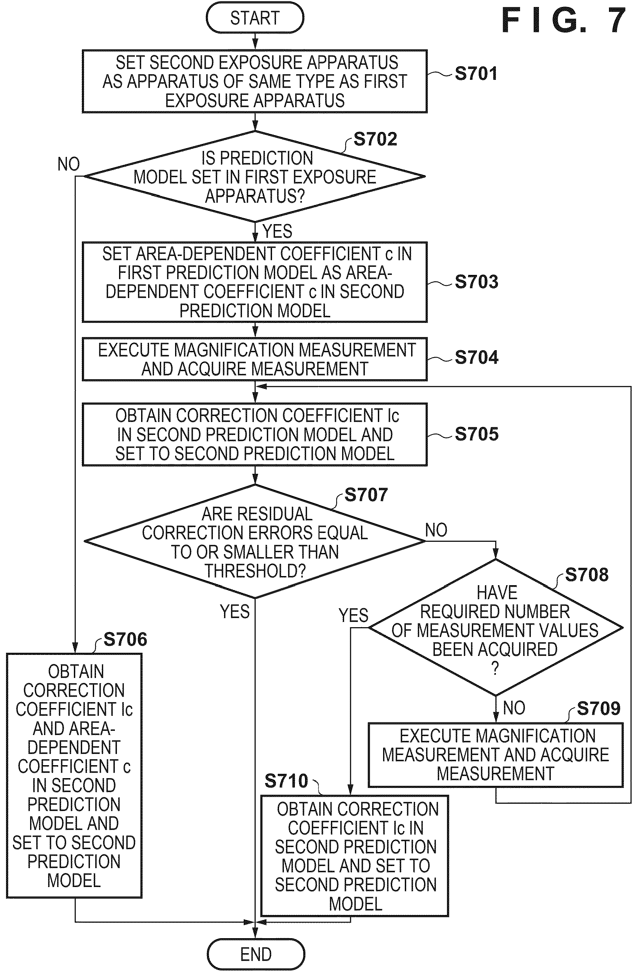

Note that in Fig. 6, the process of obtaining the prediction model is terminated after step S605, but the process of obtaining the prediction model may be continued until the prediction model set in step S605 achieves the desired prediction accuracy, as illustrated in Fig. 7. With reference to Fig. 7, a process of obtaining a prediction model that achieves the desired prediction accuracy will be described. Note that steps S701 to S706 are similar to steps S601 to S606 illustrated in Fig. 6, respectively, so that a detailed description is omitted here.

In step S707 (fourth step), using the prediction model set in step S706, magnification measurements are executed while performing exposure processes on the lot in the second exposure apparatus, and it is determined whether the residual correction errors are equal to or smaller than a threshold. More specifically, using the prediction model set in step S706, the prediction value of the fluctuation of the magnification of the second projection optical system is obtained, and it is determined whether the residual correction error, which is obtained by measuring the fluctuation of the magnification of the second projection optical system while performing correction based on the obtained prediction value, is equal to or smaller than a threshold. At this time, the exposure condition is different from the exposure condition in step S704. If the residual correction error is equal to or smaller than the threshold, it is determined that the prediction model set in step S706 achieves the desired prediction accuracy, and the process is terminated. On the other hand, if the residual correction error is larger than the threshold, it is determined that the prediction model set in step S706 does not achieve the desired prediction accuracy, and the process transitions to step S708. Note that in this embodiment, the determination as to whether the residual correction error is equal to or smaller than the threshold is made automatically in the exposure apparatus 1 (control unit 120), but the determination may be made manually by the user.

In step S708, it is determined whether the number (required number) of measurement values required to newly set the correction coefficient Ic in the prediction model applied to the second exposure apparatus have been acquired. If the required number of measurement values have not been acquired, the process transitions to step S709. If the required number of measurement values have been acquired, the process transitions to step S710.

In step S709 (fifth step), using the prediction model set in step S706, a measurement value is acquired by executing magnification measurement while performing an exposure process on the lot in the second exposure apparatus. More specifically, using the prediction model set in step S706, prediction values are obtained by predicting the fluctuation of the magnification of the second projection optical system, and measurement values, that is, a lot leading magnification and an intra-lot magnification, are acquired by measuring the fluctuation of the magnification of the second projection optical system while performing correction based on the prediction values. At this time, as the exposure condition, the transmittance of the original 104 is set high, and the X-direction aperture width mbWx of the masking blade is set large (for example, within a range of 26 mm (inclusive) to 30 mm (inclusive)) or small (for example, within a range of 10 mm (inclusive) to 14 mm (inclusive)).

In step S710 (fifth step), based on the required number of measurement values, the correction coefficient Ic (the third value, which is a value of the second coefficient) is obtained, and the obtained correction coefficient Ic is set as the new correction coefficient Ic in the prediction model applied to the second exposure apparatus. Note that it is also possible to obtain the area-dependent coefficient c based on the required number of measurement values in step S710. Hence, the area-dependent coefficient c may be obtained based on the required number of measurement values, and the obtained area-dependent coefficient c may be set as the new area-dependent coefficient c in the prediction model applied to the second exposure apparatus in place of the area-dependent coefficient c in the prediction model applied to the first exposure apparatus.

In this manner, according to this embodiment, a technique advantageous in obtaining a prediction model for predicting the fluctuation of the imaging characteristics of the projection optical system 107 is provided and, in the exposure apparatus 1, the exposure history with high accuracy can be corrected while suppressing degradation of productivity. At this time, as described above, a function of obtaining a prediction model, obtaining a prediction value by predicting the fluctuation of the imaging characteristics of the projection optical system 107 by using the prediction model, and correcting the fluctuation of the imaging characteristics based on the prediction value is implemented in the control unit 120. An exposure method including a step of obtaining a prediction model, and a step of correcting the fluctuation of the imaging characteristics of the projection optical system 107 based on a prediction value obtained by predicting the fluctuation of the imaging characteristics of the projection optical system 107 by using the prediction model also constitutes one aspect of the present disclosure.

An article manufacturing method according to an embodiment of the present disclosure is, for example, suitable to manufacture an article such as a semiconductor device, a liquid crystal display device, a flat panel display, or a MEMS. The manufacturing method includes a step of exposing a substrate applied with a photosensitive material by using the above-described exposure apparatus 1 (exposure method), and a step of developing the exposed photosensitive material. In addition, an etching step, an ion implantation step, or the like is performed on the substrate using the pattern of the developed photosensitive material as a mask to form a circuit pattern on the substrate. By repeating the steps of exposure, developing, etching, and the like, a circuit pattern formed by a plurality of layers is formed on the substrate. In a post-process, dicing (processing) is performed on the substrate bearing the circuit pattern, and chip mounting, bonding, and inspection steps are performed. The manufacturing method can also include other known steps (oxidation, deposition, vapor deposition, doping, planarization, resist removal, and the like). The article manufacturing method according to this embodiment is superior to a conventional method in at least one of the performance, quality, productivity, and production cost of the article.

Other Embodiments

Embodiment(s) of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)TM), a flash memory device, a memory card, and the like.

Various embodiments have been described in detail above but it will be understood that the present disclosure is not limited to these embodiments and encompasses all modifications, variants, alternatives and equivalents falling within the scope of the appended claims.

**Claims**

1. A method of obtaining a prediction model for predicting fluctuation of imaging characteristics of a projection optical system which is used in an exposure apparatus that exposes a substrate via an original, the method comprising:

setting a first value, which is a value of a first coefficient in a first prediction model that is set based on a result of measuring fluctuation of imaging characteristics of a first projection optical system in a first exposure apparatus including the first projection optical system, as a value of the first coefficient in a second prediction model for predicting fluctuation of imaging characteristics of a second projection optical system in a second exposure apparatus including the second projection optical system, while temporarily setting a value of a second coefficient in the second prediction model to a default value;
acquiring a measurement value by measuring fluctuation of imaging characteristics of the second projection optical system while performing correction based on a prediction value which is obtained by predicting fluctuation of imaging characteristics of the second projection optical system using the second prediction model set in the setting; and
setting a value of the second coefficient in the second prediction model to a second value, which is a value of the second coefficient in the second prediction model, obtained based on a measurement value acquired in the acquiring,
wherein the second exposure apparatus is an apparatus of the same type as the first exposure apparatus.

2. The method according to claim 1, wherein

the first coefficient is a coefficient common to the first projection optical system and the second projection optical system, and
the second coefficient is a coefficient specific to each of the first projection optical system and the second projection optical system.

3. The method according to claim 1, wherein

assuming that $\phi$ represents a prediction value of fluctuation of the imaging characteristics, N represents a timing of predicting fluctuation of the imaging characteristics, heatTime represents an exposure time, K represents a time constant, Io represents an exposure load, Dose represents an exposure amount, mbWx and mbWy represent an aperture width in a first direction and an aperture width in a second direction orthogonal to the first direction, respectively, of a masking blade defining an exposure region, slitWy represents a design value of a width of the exposure region in the second direction, Dose0 represents a reference exposure amount, Wx0 and Wy0 represent a width in the first direction and a width in the second direction, respectively, of an reference exposure region, v0 represents a reference scan speed, T represents a transmittance of the original, T0 represents a transmittance of a reference original, Ic represents a saturation amount at a unit exposure load, and c represents an area-dependent coefficient that indicates an influence on an exposure load relative to an aperture width of the masking blade, the prediction model is expressed by

$$\phi \, N = \text{lo} - (\text{lo} - \phi N - 1) \times \exp((-1) \times \text{heatTime}/K)$$

$\text{lo} = \text{Ic} \times \{\text{Dose} \times \text{mbWy} \times ((1/\text{HeatTime})/\text{slitWy})\}/\{\text{Dose}_0 \times \text{Wy}_0 \times \text{v}_0/\text{slitWy}/(\text{slitWy} + \text{Wy}_0)\} \times T/T_0 \times (\text{mbWx}/\text{Wx}_0) \times ((\exp(c) + \exp(-c)))/((\exp(c \times (\text{mbWx}/\text{Wx}0)) + \exp(-c \times (\text{mbWx}/\text{Wx}0))))$,

the first coefficient includes the area-dependent coefficient, and
the second coefficient includes the saturation amount at the unit exposure load.

4. The method according to claim 1, further comprising:

determining whether a residual correction error, which is obtained by measuring fluctuation of imaging characteristics of the second projection optical system while performing correction based on a prediction value of fluctuation of imaging characteristics of the second projection optical system, which is obtained using the second prediction model decided in the setting the value, is not more than a threshold, and
newly setting a value of the second coefficient in the second prediction model in a case where the residual correction error is larger than a threshold.

5. The method according to claim 4, wherein

the newly setting includes
acquiring a measurement value by measuring fluctuation of imaging characteristics of the second projection optical system while performing correction based on a prediction value of fluctuation of imaging characteristics of the second projection optical system, which is obtained using the second prediction model decided in the setting the value, and
setting a value of the second coefficient in the second prediction model to a third value, which is a value of the second coefficient in the second prediction model, obtained based on the measurement value acquired in the acquiring the measurement value.

6. The method according to claim 1, wherein
in the setting, the first prediction model, in which a value of the first coefficient and a value of the second coefficient are set, is acquired from the first exposure apparatus, and the first value of the first coefficient in the first prediction model is deployed as a value of the first coefficient in the second prediction model.

7. The method according to claim 1, wherein
the imaging characteristics include at least one of magnification, focus, distortion, astigmatism, spherical aberration, comatic aberration, and wave aberration.

8. An exposure apparatus that exposes a substrate via an original, comprising:

a projection optical system configured to project a pattern of the original onto the substrate; and
a control unit configured to obtain a prediction model for predicting fluctuation of imaging characteristics of the projection optical system, obtain a prediction value by predicting fluctuation of imaging characteristics of the projection optical system by using the prediction model, and perform correction based on the prediction value, wherein

the control unit performs

setting a first value, which is a value of a first coefficient in a first prediction model that is set based on a result of measuring fluctuation of imaging characteristics of a projection optical system, which is different from the projection optical system, in another exposure apparatus including the different projection optical system, as a value of the first coefficient in a second prediction model for predicting fluctuation of imaging characteristics of the projection optical system, while temporarily setting a value of a second coefficient in the second prediction model to a default value,

acquiring a measurement value by measuring fluctuation of imaging characteristics of the projection optical system while performing correction based on a prediction value obtained by predicting fluctuation of imaging characteristics of the projection optical system using the second prediction model set in the setting, and

setting a value of the second coefficient in the second prediction model to a second value, which is a value of the second coefficient in the second prediction model, obtained based on a measurement value acquired in the acquiring, and

the apparatus is an apparatus of the same type as the other exposure apparatus.

9. An exposure method of exposing a substrate via an original, comprising:

obtaining a prediction model for predicting fluctuation of imaging characteristics of a projection optical system configured to project a pattern of the original onto the substrate; and

performing correction based on a prediction value obtained by predicting fluctuation of imaging characteristics of the projection optical system using the prediction model,

wherein the obtaining includes

setting a first value, which is a value of a first coefficient in a first prediction model that is set based on a result of measuring fluctuation of imaging characteristics of a projection optical system different from the projection optical system, as a value of the first coefficient in a second prediction model for predicting fluctuation of imaging characteristics of the projection optical system, while temporarily setting a value of a second coefficient in the second prediction model to a default value,

acquiring a measurement value by measuring fluctuation of imaging characteristics of the projection optical system while performing correction based on a prediction value obtained by predicting fluctuation of imaging characteristics of the projection optical system using the second prediction model set in the setting, and

setting a value of the second coefficient in the second prediction model to a second value, which is a value of the second coefficient in the second prediction model, obtained based on a measurement value acquired in the acquiring, and

an exposure apparatus including the projection optical system is an apparatus of the same type as another exposure apparatus including the different projection optical system.

10. An information processing apparatus comprising:

a memory; and

a CPU configured to perform a process of obtaining a prediction model for predicting fluctuation of imaging characteristics of a projection optical system which is used in an exposure apparatus that exposes a substrate via an original,

wherein the process includes

setting a first value, which is a value of a first coefficient in a first prediction model that is set based on a result of measuring fluctuation of imaging characteristics of a first projection optical system in a first exposure apparatus including the first projection optical system, as a value of the first coefficient in a second prediction model for predicting fluctuation of imaging characteristics of a second projection optical system in a second exposure apparatus including the second projection optical system, while temporarily setting a value of a second coefficient in the second prediction model to a default value,

acquiring a measurement value by measuring fluctuation of imaging characteristics of the second projection optical system while performing correction based on a prediction value which is obtained by predicting fluctuation of imaging characteristics of the second projection optical system using the second prediction model set in the setting, and

setting a value of the second coefficient in the second prediction model to a second value, which is a value of the second coefficient in the second prediction model, obtained based on a measurement value acquired in the acquiring, and

the second exposure apparatus is an apparatus of the same type as the first exposure apparatus.

11. An article manufacturing method comprising:

exposing a substrate using an exposure apparatus defined in claim 8;
developing the substrate exposed; and
manufacturing an article from the substrate developed.

12. A program for causing a computer to execute each step of a method defined in claim 1.

# F I G. 1

# F I G. 2

# FIG. 3

# FIG. 4

● RECIPE A    △ RECIPE B    □ RECIPE C    × RECIPE D

RESIDUAL CORRECTION ERROR [ppm]

SUBSTRATE NUMBER

# FIG. 5

EP 4 779 404 A1

● RECIPE A    △ RECIPE B    □ RECIPE C    × RECIPE D

RESIDUAL
CORRECTION
ERROR
[ppm]

SUBSTRATE NUMBER

# F I G. 6

START

**S601**
SET SECOND EXPOSURE APPARATUS
AS APPARATUS OF SAME TYPE
AS FIRST EXPOSURE APPARATUS

**S602**
IS PREDICTION
MODEL SET IN FIRST EXPOSURE
APPARATUS?

NO

YES

**S606**
OBTAIN CORRECTION COEFFICIENT Ic
AND AREA-DEPENDENT COEFFICIENT c
IN SECOND PREDICTION MODEL
AND SET TO SECOND PREDICTION
MODEL

**S603**
SET AREA-DEPENDENT COEFFICIENT c
IN FIRST PREDICTION MODEL
AS AREA-DEPENDENT COEFFICIENT c
IN SECOND PREDICTION MODEL

**S604**
EXECUTE MAGNIFICATION
MEASUREMENT AND ACQUIRE
MEASUREMENT

**S605**
OBTAIN CORRECTION COEFFICIENT
Ic IN SECOND PREDICTION MODEL
AND SET TO SECOND PREDICTION
MODEL

END

# FIG. 7

START

SET SECOND EXPOSURE APPARATUS AS APPARATUS OF SAME TYPE AS FIRST EXPOSURE APPARATUS — S701

IS PREDICTION MODEL SET IN FIRST EXPOSURE APPARATUS? S702

NO

YES

SET AREA-DEPENDENT COEFFICIENT c IN FIRST PREDICTION MODEL AS AREA-DEPENDENT COEFFICIENT c IN SECOND PREDICTION MODEL — S703

EXECUTE MAGNIFICATION MEASUREMENT AND ACQUIRE MEASUREMENT — S704

OBTAIN CORRECTION COEFFICIENT lc IN SECOND PREDICTION MODEL AND SET TO SECOND PREDICTION MODEL — S705

ARE RESIDUAL CORRECTION ERRORS EQUAL TO OR SMALLER THAN THRESHOLD? S707

NO

YES

HAVE REQUIRED NUMBER OF MEASUREMENT VALUES BEEN ACQUIRED? S708

YES

NO

EXECUTE MAGNIFICATION MEASUREMENT AND ACQUIRE MEASUREMENT — S709

OBTAIN CORRECTION COEFFICIENT lc AND AREA-DEPENDENT COEFFICIENT c IN SECOND PREDICTION MODEL AND SET TO SECOND PREDICTION MODEL — S706

OBTAIN CORRECTION COEFFICIENT lc IN SECOND PREDICTION MODEL AND SET TO SECOND PREDICTION MODEL — S710

END

| | Europäisches Patentamt European Patent Office Office européen des brevets | **EUROPEAN SEARCH REPORT** | Application Number EP 26 15 2268 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 2019 117418 A (NIKON) 18 July 2019 (2019-07-18) * paragraph [0039] * * figure 1 * * claim 1 * ----- | 1-12 | INV. G03F7/00 |
| A | US 2024/126182 A1 (MOIZUMI) 18 April 2024 (2024-04-18) * paragraph [0036] * * figures 1-5 * ----- | 1-12 | |
| A | DE 10 2006 009703 B3 (TEXAS INSTRUMENTS) 30 August 2007 (2007-08-30) * paragraphs [0013] - [0015] * * figure 1 * ----- | 1-12 | |
| | | | **TECHNICAL FIELDS SEARCHED (IPC)** G03F |

The present search report has been drawn up for all claims

| Place of search | Date of completion of the search | Examiner |
|---|---|---|
| Munich | 29 May 2026 | Subke, Kai-Olaf |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 ........................................................................................

& : member of the same patent family, corresponding document

EPO FORM 1503 03.82 (P04C01)

# EP 4 779 404 A1

## ANNEX TO THE EUROPEAN SEARCH REPORT
## ON EUROPEAN PATENT APPLICATION NO.

EP 26 15 2268

29-05-2026

| Patent document cited in search report | Publication date | Patent family member(s) | | Publication date |
|---|---|---|---|---|
| JP 2019117418 A | 18-07-2019 | JP | 6744596 B2 | 19-08-2020 |
| | | JP | 2019117418 A | 18-07-2019 |
| US 2024126182 A1 | 18-04-2024 | CN | 117891137 A | 16-04-2024 |
| | | JP | 7297136 B1 | 23-06-2023 |
| | | JP | 2024057976 A | 25-04-2024 |
| | | KR | 20240051826 A | 22-04-2024 |
| | | TW | 202431004 A | 01-08-2024 |
| | | US | 2024126182 A1 | 18-04-2024 |
| DE 102006009703 B3 | 30-08-2007 | DE | 102006009703 B3 | 30-08-2007 |
| | | US | 2008002171 A1 | 03-01-2008 |

EPO FORM P0459

**EP 4 779 404 A1**

## REFERENCES CITED IN THE DESCRIPTION

**Patent documents cited in the description**

- JP 2013115348 A